# EUROPÄISCHE PATENTSCHRIFT

(11) **EP 2 436 798 B1**
(45) Veröffentlichungstag und Bekanntmachung des Hinweises auf die Patenterteilung: **17.09.2014**
(21) Anmeldenummer: 11008609.7
(22) Anmeldetag: 04.12.2009
(51) Int. Cl.: C23C 8/04, C23C 14/04, C23C 16/04, F01D 5/28

(54) **Maskierungsmaterial, Maskierungsschicht und Verfahren zum Maskieren eines Substrats**
Masking material, masking device and method for masking a substrate
Matériel de masquage, couche de masquage et procédé de masquage d'un substrat

(43) Veröffentlichungstag der Anmeldung: 04.04.2012
(62) Teilanmeldung aus: 09015078.0
(73) Patentinhaber: Siemens Aktiengesellschaft, 80333 München (DE)
(72) Erfinder: Berndt, Thomas, 12524 Berlin (DE); Ladru, Francis-Jurjen, Dr., 13587 Berlin (DE)

(56) Entgegenhaltungen:
- EP-A2- 1 076 111
- DE-C1- 4 344 061
- US-A- 4 467 016
- US-A1- 2006 105 160
- US-B1- 6 253 441

## Beschreibung

Die Erfindung betrifft ein Maskierungsmaterial, ein Verfahren zum Maskieren und ein Verfahren zum Beschichten.

Bei Beschichtungsverfahren, insbesondere bei denen, die eine Gasphase verwenden, wie beim PVD- oder CVD-Verfahren, müssen bestimmte Bereiche besonders gut gasdicht geschützt werden, weil an diesen Stellen keine Beschichtung aufgebracht werden soll.

Bekannt sind verschiedene Verfahren, bei dem verschiedene große Pulvermischungen mechanisch miteinander vermischt werden oder glashaltige Substanzen aufgebracht werden, die besonders dicht sein sollen, die aber wieder schwer zu entfernen sind.

DE4344016 offenbart eine Maskierungsschicht und ein Verfahren zur Maskierung von Bauteilen. Eine erste Schicht besteht aus Al₂O₃ Partikeln und eine zweite Schicht besteht aus einem Metalllegierungspulver.

Es ist daher Aufgabe der Erfindung oben genanntes Problem zu lösen.

Die Aufgabe wird gelöst durch ein Maskierungsmaterial gemäß Anspruch 1, eine Maskierungsschicht nach Anspruch 5 und ein Verfahren zum Maskieren gemäß Anspruch 8.

Es zeigen:
- Figur 1: einen schematischen Ablauf des Verfahrens zum Maskieren eines Substrats,
- Figur 2, 3: ein Beschichtungsverfahren,
- Figur 4: perspektivisch eine Turbinenschaufel,
- Figur 5: perspektivisch eine Gasturbine und
- Figur 6: eine Liste von Superlegierungen.

Die Figuren und die Beschreibung stellen nur Ausführungsbeispiele der Erfindung dar.

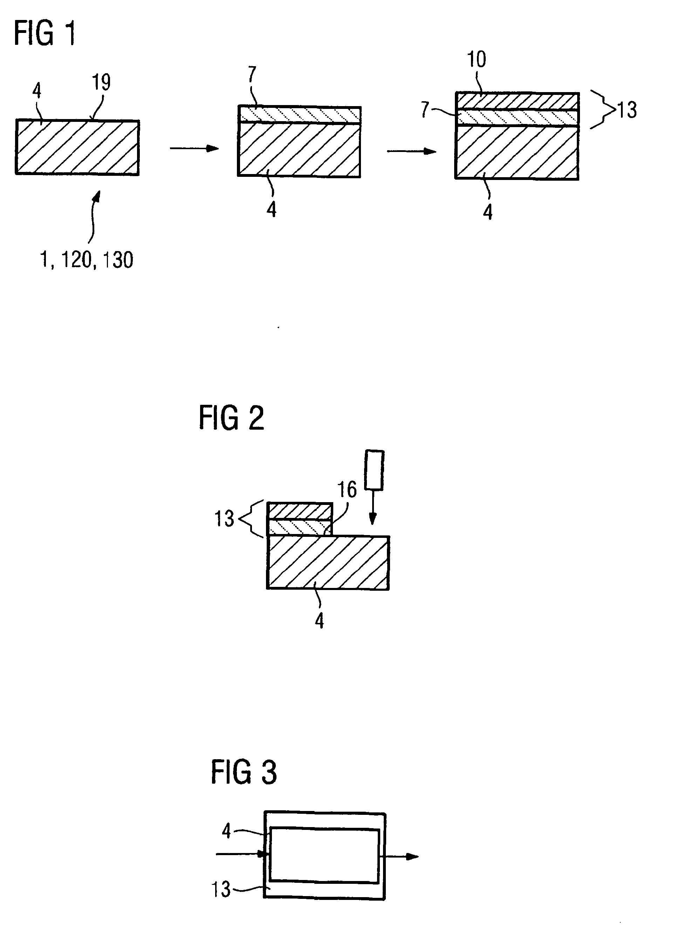

In Figur 1 ist ein Substrat 4 mit einer Oberfläche 19 gezeigt, das ein Substrat eines Bauteils 1, 120, 130 darstellt.

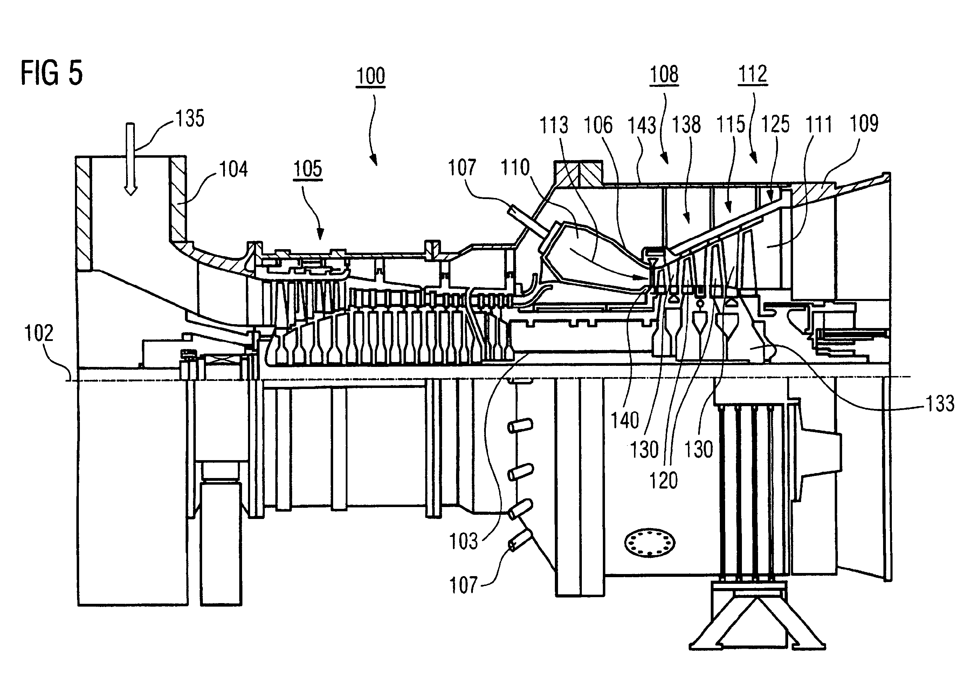

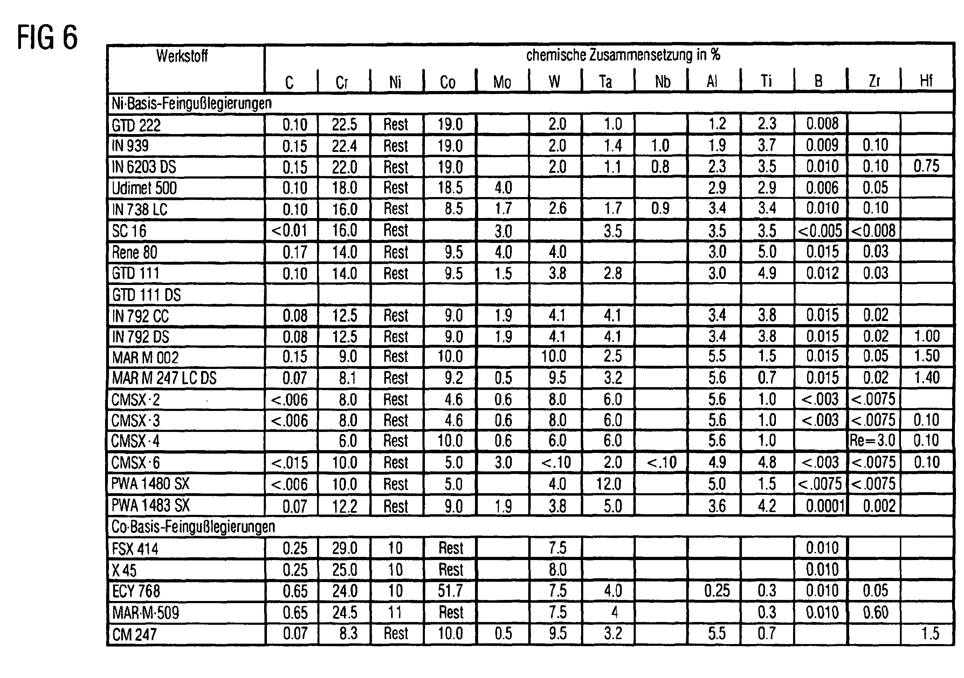

Es ist insbesondere bei Gasturbinen 100 (Fig. 5) eine Turbinenschaufel, die insbesondere aus Werkstoffen gemäß Figur 6 gebildet ist.

In einem ersten Schritt wird vorzugsweise ein Keramikpulver als Schicht 7 auf die Oberfläche 19 aufgebracht.

Das keramische Pulver kann durch Sprühen oder durch andere Verfahren mit oder ohne Binder aufgetragen werden.

Das keramische Pulver kann insbesondere eine Oxidkeramik, Zirkonoxid, Aluminiumoxid, Titanoxid,
ein Perowskite, ein Spinell, ein Pyrochlore, und/oder Bornitrid oder Mischungen daraus umfassen.

Erfindungsgemäß wird eine Mischung aus Al₂O₃ / TiO₂ oder ZrO₂ / TiO₂ oder Al₂O₃ / ZrO₂ oder BN / TiO₂ oder BN / Al₂O₃ oder BN/ZrO₂ verwendet.

Die Mischungsverhältnisse betragen vorzugsweise 93/7 oder 87/13.

In einem zweiten Verfahrensschritt wird vorzugsweise ein metallisches Pulver als Schicht 10 auf die keramische Pulverschicht 7 aufgebracht.

Dieses kann auch teilweise in die offenen Poren der keramischen Schicht 7 eindringen.

Dies bildet zusammen eine Maskierungsschicht 13.

Diese zwei Schritte können auch vorzugsweise zumindest einmal, insbesondere nur einmal wiederholt werden, so dass eine mehrlagige Maskierungsschicht 13 entsteht: Keramik - Metall - Keramik - Metall.

Vorzugsweise reichen eine keramische und eine metallische Schicht aus.

Noch bessere Ergebnisse werden mit gradierten Übergängen zwischen Keramik und Metall erzielt.

Das metallische Pulver ist insbesondere ein Metall des Substrats, also vorzugsweise Nickel (Ni), Kobalt (Co), Chrom (Cr), Aluminium (Al) oder Mischungen daraus, das oder die vorzugsweise mit einem Beschichtungsmaterial gut reagieren kann oder können. Insbesondere wird Nickel verwendet.

Es kann auch eine Legierung der oben genannten Metalle zum Einsatz kommen (NiAl, ...)

Die Korngrößenverteilung beträgt allgemein vorzugsweise: beim keramischen Pulver 0.1µm - 20µm (100nm - 20µm) beim metallischen Pulver 5µm - 25µm (1µm - 25µm).

Dieses Schichtsystem aus der unteren keramischen Pulverschicht und der oberen metallischen Pulverschicht 10 bildet eine insbesondere gasdichte Maskierungsschicht 13.

Eine solche Maskierungsschicht 13 kann lokal auf Stellen 16 aufgebracht werden, bei denen keine Beschichtung erfolgen soll (Figur 2) .

Hierbei kann das Maskierungsmaterial bei beliebigen Beschichtungsverfahren verwendet werden, insbesondere jedoch bei Gasphasenbeschichtungsverfahren, wie z.B. PVD, CVD oder anderen Verfahren, bei denen das Beschichtungsmaterial in einer Dampf- oder Gasform vorliegt.

Ebenso kann das gesamte äußere Substrat 4 geschützt werden, wenn z.B. ein hohles Bauteil im Inneren beschichtet wird, z.B. chromiert oder alitiert wird, und es nicht immer verhindert werden kann, dass Beschichtungsmaterial aus dem hohlen Bauteil wieder auftritt und sich auf nicht geschützte äußere Oberflächen des Subrats 4 niederschlagen soll.

Ebenso kann als Maskierungsmaterial eine mechanische Mischung aus keramischem Pulver und metallischen Pulver mit den oben aufgelisteten bevorzugten Materialien und Auftragungsarten verwendet werden.

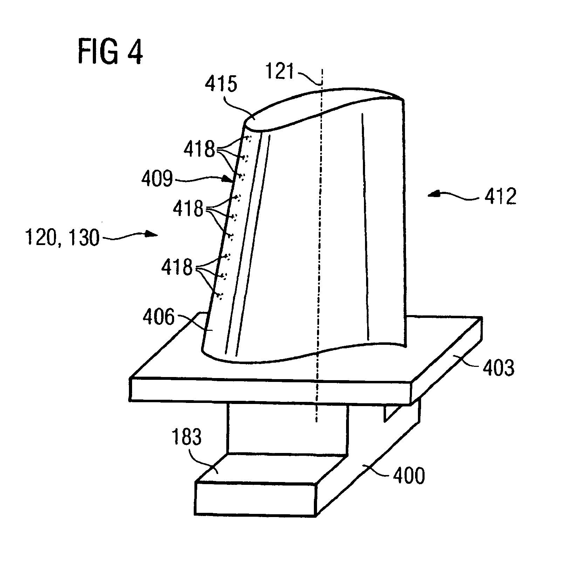

Die Figur 4 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.

Als Leitschaufel 130 kann die Schaufel 130 an ihrer Schaufelspitze 415 eine weitere Plattform aufweisen (nicht dargestellt) .

Im Befestigungsbereich 400 ist ein Schaufelfuß 183 gebildet, der zur Befestigung der Laufschaufeln 120, 130 an einer Welle oder einer Scheibe dient (nicht dargestellt).

Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.

Solche Superlegierungen sind beispielsweise aus der EP 1 204 776 B1, EP 1 306 454, EP 1 319 729 A1, WO 99/67435 oder WO 00/44949 bekannt.

Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.

Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.

Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures). Solche Verfahren sind aus der US-PS 6,024,792 und der EP 0 892 090 A1 bekannt.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.

Die Dichte liegt vorzugsweise bei 95% der theoretischen Dichte.

Auf der MCrAlX-Schicht (als Zwischenschicht oder als äußerste Schicht) bildet sich eine schützende Aluminiumoxidschicht (TGO = thermal grown oxide layer).

Vorzugsweise weist die Schichtzusammensetzung Co-30Ni-28Cr-8A1-0,6Y-0,7Si oder Co-28Ni-24Cr-10Al-0,6Y auf. Neben diesen kobaltbasierten Schutzbeschichtungen werden auch vorzugsweise nickelbasierte Schutzschichten verwendet wie Ni-10Cr-12Al-0,6Y-3Re oder Ni-12Co-21Cr-11Al-0,4Y-2Re oder Ni-25Co-17Cr-10Al-0,4Y-1,5Re.

Auf der MCrAlX kann noch eine Wärmedämmschicht vorhanden sein, die vorzugsweise die äußerste Schicht ist, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.

Die Wärmedämmschicht bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

Die Figur 5 zeigt beispielhaft eine Gasturbine 100 in einem Längsteilschnitt.

Die Gasturbine 100 weist im Inneren einen um eine Rotationsachse 102 drehgelagerten Rotor 103 mit einer Welle 101 auf, der auch als Turbinenläufer bezeichnet wird.

Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.

Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.

An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet.

Solche Superlegierungen sind beispielsweise aus der EP 1 204 776 B1, EP 1 306 454, EP 1 319 729 A1, WO 99/67435 oder WO 00/44949 bekannt.

Ebenso können die Schaufeln 120, 130 Beschichtungen gegen Korrosion (MCrAlX; M ist zumindest ein Element der Gruppe Eisen (Fe), Kobalt (Co), Nickel (Ni), X ist ein Aktivelement und steht für Yttrium (Y) und/oder Silizium, Scandium (Sc) und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1.

Auf der MCrAlX kann noch eine Wärmedämmschicht vorhanden sein, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.

Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

## Patentansprüche

1. Maskierungsmaterial,
das
ein keramisches Pulver und
ein metallisches Pulver
aufweist,
bei dem das keramische Pulver Mischungen aus Al₂O₃/TO0₂, BN/TiO₂, ZrO₂/TiO₂, Al₂O₃/ZrO₂, BN/Al₂O₃ oder BN/ZrO₂ aufweist,
wobei das metallische Pulver
Nickel (Ni), Aluminium (Al), Kobalt (Co) und/oder Chrom (Cr)
sowie Mischungen oder
Legierungen daraus darstellt,
insbesondere Nickel (Ni),
ganz insbesondere nur Nickel (Ni)
aufweist.

2. Maskierungsmaterial nach Anspruch 1, das nur ein einziges metallisches Material aufweist.

3. Maskierungsmaterial nach Anspruch 1 oder 2, das nur aus Keramik und Metall besteht.

4. Maskierungsschicht (13),
die ein Maskierungsmaterial gemäß Anspruch 1, 2, 3 aufweist,
insbesondere daraus besteht.

5. Maskierungsschicht (13),
die mehrlagig aufgebaut ist und
zumindest eine untere keramische Schicht (7) aus einem keramischen Pulver,
wobei das keramische Pulver Mischungen aus Al₂O₃/TiO₂, BN/TiO₂, ZrO₂/TiO₂, Al₂O₃/ZrO₂, BN/Al₂O₃ oder BN/ZrO₂ aufweist und
zumindest eine obere metallische Schicht (10) aus einem metallischen Pulver aufweist,
wobei das metallische Pulver
Nickel (Ni), Aluminium (A1), Kobalt (Co) und/oder Chrom (Cr)
sowie Mischungen oder
Legierungen daraus darstellt,
insbesondere Nickel (Ni),
ganz insbesondere nur Nickel (Ni)
aufweist oder ein Material nach Anspruch 2 aufweist, insbesondere auf der keramische Schicht (7),
und insbesondere nach Anspruch 3 ausgebildet ist.

6. Maskierungsschicht nach Anspruch 5,
die zumindest zwei keramische und
zumindest zwei metallische Schichten aufweist, insbesondere in alternierender Reihenfolge,
ganz insbesondere mit einer untersten keramischen Schicht.

7. Maskierungsschicht nach Anspruch 5 oder 6,
die nur zwei metallische und nur zwei keramische Schichten aufweist.

8. Verfahren zum Maskieren eines Substrats (4),
bei dem auf die Oberfläche (16, 19) des Substrats (4) ein Maskierungsmaterial gemäß Anspruch 1, 2, 3 oder 4 aufgebracht wird.

## Claims

1. Masking material
which comprises
a ceramic powder and
a metallic powder,
wherein the ceramic powder comprises mixtures of Al₂O₃/TiO₂, BN/TiO₂, ZrO₂/TiO₂, Al₂O₃/ZrO₂, BN/Al₂O₃ or BN/ZrO₂,
the metallic powder being
nickel (Ni), aluminum (Al), cobalt (Co) and/or chromium (Cr)
and mixtures or
alloys thereof,
in particular comprises nickel (Ni),
very particularly only nickel (Ni).

2. Masking material according to Claim 1,
which comprises only a single metallic material.

3. Masking material according to Claim 1 or 2,
which consists only of ceramic and metal.

4. Masking layer (13)
which comprises a masking material according to Claim 1, 2 or 3
in particular consists thereof.

5. Masking layer (13)
which has a multilayer design and comprises
at least a lower ceramic layer (7) consisting of a ceramic powder,
the ceramic powder comprising mixtures of Al₂O₃/TiO₂, BN/TiO₂, ZrO₂/TiO₂, Al₂O₃/ZrO₂, BN/Al₂O₃ or BN/ZrO₂, and comprises at least an upper metallic layer (10) consisting of a metallic powder, the metallic powder being
nickel (Ni), aluminum (Al), cobalt (Co) and/or chromium (Cr)
and mixtures or
alloys thereof,
in particular comprises nickel (Ni),
very particularly only nickel (Ni), or comprises a material according to Claim 2,
in particular on the ceramic layer (7),
and is formed in particular according to Claim 3.

6. Masking layer according to Claim 5,
which comprises at least two ceramic and
at least two metallic layers,
in particular in alternating sequence,
very particularly with a lowermost ceramic layer.

7. Masking layer according to Claim 5 or 6,
which comprises only two metallic and only two ceramic layers.

8. Process for masking a substrate (4),
in which process a masking material according to Claim 1, 2, 3 or 4 is applied to the surface (16, 19) of the substrate (4).

## Revendications

1. Matière de masquage,
qui comprend
une poudre céramique et
une poudre métallique,
dans laquelle la poudre céramique comprend des mélanges d'Al₂O₃/TiO₂, de BN/TiO₂, de ZrO₂/TiO₂, d'Al₂O₃/ZrO₂, de BN/Al₂O₃ ou de BN/ZrO₂,
dans laquelle la poudre métallique représente du nickel ( Ni ), de l'aluminium ( Al ), du cobalt ( Co ) et/ou du chrome ( Cr )
ainsi que des mélanges ou
des alliages,
en étant notamment du nickel ( Ni ),
tout particulièrement seulement du nickel ( Ni ).

2. Matière de masquage suivant la revendication 1,
qui n'a qu'une matière métallique unique.

3. Matière de masquage suivant la revendication 2,
qui n'est constituée que de céramique et de métal.

4. Couche ( 13 ) de masquage,
qui a une matière de masquage suivant la revendication 1, 2, ou 3,
en en étant notamment constituée.

5. Couche ( 13 ) de masquage,
qui est formée de plusieurs strates et
qui a au moins une couche ( 7 ) céramique inférieure en une poudre céramique,
dans laquelle la poudre céramique comprend des mélanges d'Al₂O₃/TiO₂, de BN/TiO₂, de ZrO₂/TiO₂, d'Al₂O₃/ZrO₂, de BN/Al₂O₃ ou de BN/ZrO₂
et
au moins une couche ( 10 ) métallique supérieure en une poudre métallique,
dans laquelle la poudre métallique
représente du nickel ( Ni ), de l'aluminium ( Al ), du cobalt ( Co ) et/ou du chrome ( Cr )
ainsi que leurs mélanges
ou leurs alliages,
en étant notamment du nickel ( Ni ),
tout particulièrement seulement du nickel ( Ni ) ou une matière suivant la revendication 2,
en étant constituée notamment sur la couche ( 7 ) céramique, et notamment suivant la revendication 3.

6. Couche de masquage suivant la revendication 5,
qui a au moins deux couches céramiques et
au moins deux couches métalliques,
notamment en alternance,
en ayant tout particulièrement une couche céramique la plus basse.

7. Couche de masque suivant la revendication 5 ou 6,
qui n'a que deux couches métalliques et que deux couches céramiques.

8. Procédé de masquage d'un substrat ( 4 ),
dans lequel on dépose sur la surface ( 16, 19 ) du substrat ( 4 ) une matière de masquage suivant la revendication 1, 2, 3 ou 4.
